# EUROPEAN PATENT APPLICATION

(11) **EP 2 408 014 A1**
(43) Date of publication of application: **18.01.2012**
(21) Application number: 10750752.7
(22) Date of filing: 05.03.2010
(51) Int. Cl.: H01L 31/04, H01B 1/06

(54) **CONNECTION SHEET FOR SOLAR BATTERY CELL ELECTRODE, PROCESS FOR MANUFACTURING SOLAR CELL MODULE, AND SOLAR CELL MODULE**

(30) Priority: 11.03.2009 JP 2009057580
(71) Applicant: Shin-Etsu Chemical Co., Ltd., Tokyo 100-0004 (JP)
(72) Inventor: AZECHI Syuichi, Annaka-shi Gunma 379-0224 (JP); SAKURAI Ikuo, Annaka-shi Gunma 379-0224 (JP); HOTTA Masakatsu, Annaka-shi Gunma 379-0224 (JP); HASHIMOTO Takeshi, Annaka-shi Gunma 379-0224 (JP)
(74) Representative: Stoner, Gerard Patrick
(86) International application number: PCT/JP2010/053604
(87) International publication number: WO 2010/103998

(57) **Abstract**

Disclosed is a connection sheet for a solar battery cell electrode, which is a polymer sheet for use in the connection between an electrode for extracting an electric power from a solar battery cell and a wiring member through an electrically conductive adhesive material by heating and pressurizing, and which is intercalated between a heating/pressurizing member and the wiring member upon use.

## Description

### TECHNICAL FIELD

This invention relates to a solar cell electrode connection-providing sheet and a method for the manufacture of a solar cell module using the sheet. More particularly, it relates to a solar cell electrode connection-providing sheet in the form of a polymer sheet which is used when an electrode for extracting power from the solar cell and an interconnect member are connected via an electroconductive adhesive material, typically an electroconductive resin adhesive, by applying heat and pressure across them, and which has heat resistance, minimized degradation even on press bonding at high temperature, and durability against mechanical stresses; a method for the manufacture of a solar cell module using the sheet; and a solar cell module manufactured thereby and free of warp and crack problems.

### BACKGROUND ART

Solar cells have electrodes to which electroconductive interconnect members are connected for extracting power from the cells. The interconnect member used in most cases is a copper foil of flat rectangular shape which is surface coated with solder. The electrode of the solar cell and the interconnect member are connected with solder (Patent Documents 1 and 2: JP-A 2004-204256 and JP-A 2005-50780). Since relatively high temperatures are necessary for such soldering, stresses are applied to the connect structure due to the difference in coefficient of thermal shrinkage among the semiconductor structure responsible for power generation, the electrode, the solder, and the electrode member, the stresses causing the solar cell to be warped and cracked.

As the countermeasure to this problem, many techniques for mitigating the stresses associated with soldering were proposed (Patent Documents 3 to 6: JP-A 2006-54355, JP-A 2005-191200, JP-A 2005-302902, and JP-A S61-284973). However, since these countermeasures were not sufficient, it was proposed to use an electroconductive resin adhesive comprising an insulating resin and electroconductive particles instead of the solder (Patent Documents 7 to 11: JP-A 2005-101519, JP-A 2007-158302, JP-A 2007-214533, JP-A 2008-294383, and JP-A 2008-300403).

To connect a solar cell electrode and an interconnect member using the electroconductive resin adhesive comprising an insulating resin and electroconductive particles, heating and press bonding steps are necessary.
The technique of connecting fine lead electrodes together by using an anisotropic electroconductive adhesive comprising an insulating resin and electroconductive particles and applying heat and pressure has been widely used in practice, mainly in the field of liquid crystal displays. The silicone rubber sheet used in such a situation between a heat/pressure member and a member to be connected is well known (Patent Documents 12 to 14: JP-A H05-198344, JP-A H06-36853, and JP-A H06-289352).

Also proposed are a silicone rubber in which carbon black having a volatile content (exclusive of water) of up to 0.5% is incorporated for improving heat resistance (Patent Document 15: JP-A H07-11010); a heat press bonding silicone rubber sheet in which carbon black having a BET specific surface area of at least 100 m²/g is incorporated for further improving heat resistance (Patent Document 16: JP-A 2003-261769); and a fluorochemical material-laminated sheet (Patent Document 17: JP 3169501).

However, it has not been proposed or investigated that when a power-extracting electrode of a solar cell and an interconnect member are connected by using the electroconductive adhesive comprising an insulating resin and electroconductive particles and applying heat and pressure, a polymer sheet is interposed between a heat/pressure member and the interconnect member. As a matter of course, no investigations have been made on the material and structure of that sheet. It is noted that silicone rubbers having metal silicon powder compounded therein are known from Patent Documents 18 to 22 (JP-A H03-14873, JP-A 2000-63670, JP-A 2007-138100, JP-A 2007-171946, and JP-A 2007-311628). It has not been contemplated to apply these silicone rubbers as the silicone rubber sheet used in the step of connecting a solar cell electrode and an interconnect member, and no attempts have been made to optimize these silicone rubbers in order to solve the warp and crack problems of solar cells.

### PRIOR-ART DOCUMENTS

### PATENT DOCUMENT

Patent Document 1: JP-A 2004-204256
Patent Document 2: JP-A 2005-50780
Patent Document 3: JP-A 2006-54355
Patent Document 4: JP-A 2005-191200
Patent Document 5: JP-A 2005-302902
Patent Document 6: JP-A S61-284973
Patent Document 7: JP-A 2005-101519
Patent Document 8: JP-A 2007-158302
Patent Document 9: JP-A 2007-214533
Patent Document 10: JP-A 2008-294383
Patent Document 11: JP-A 2008-300403
Patent Document 12: JP-A H05-198344
Patent Document 13: JP-A H06-36853
Patent Document 14: JP-A H06-289352
Patent Document 15: JP-A H07-11010
Patent Document 16: JP-A 2003-261769
Patent Document 17: JP 3169501
Patent Document 18: JP-A H03-14873
Patent Document 19: JP-A 2000-63670
Patent Document 20: JP-A 2007-138100
Patent Document 21: JP-A 2007-171946
Patent Document 22: JP-A 2007-311628

### SUMMARY OF INVENTION

### Problem to Be Solved by Invention

An object of the invention, which has been made under the foregoing circumstances, is to provide a solar cell electrode connection-providing sheet which is used, when an electrode for extracting power from the solar cell and an interconnect member are connected via an electroconductive adhesive by applying heat and pressure across them, as being interposed between a heat/pressure member and the interconnect member, and has heat resistance and durability, and does not stick to solder or the metal of the interconnect member, so that solar cells and solar cell modules of quality may be manufactured in high yields; a method for the manufacture of a solar cell module using the connection-providing sheet; and a solar cell module manufactured thereby.

### Means for Solving Problem

Making extensive investigations in order to attain the above object, the inventors have found that when a solar cell electrode and an interconnect member are connected via an electroconductive adhesive, typically an electroconductive resin adhesive, by applying heat and pressure across them, interposing a polymer sheet preferably comprising at least one of heat resistant resin, fluoro-rubber and silicone rubber between a heat/pressure member and the interconnect member is effective for accommodating the warp and crack of a solar cell constructed in thin-film structure. It has also been found very important to optimize the hardness, elasticity, heat conduction and non-stickiness of the polymer sheet. Specifically, it has been found that a heat conductive filler is preferably incorporated to enhance heat conduction, and that when metal silicon powder or crystalline silicon dioxide powder is used, the polymer sheet is reduced in compression set, minimizing the degradation due to permanent deformation caused by press bonding. Accordingly, the use of a solar cell electrode connection-providing sheet in the form of an optimized polymer sheet ensures that in the step of manufacturing a solar battery consisting of a single cell or a solar cell module, the electroconductive adhesive is readily bonded under the impetus of heat and pressure without a lowering of power generation efficiency due to contact failure, while the connection-providing sheet does not stick to the interconnect member and the electroconductive adhesive. The intended connection can be provided by iterative use of an identical portion of the connection-providing sheet. The invention is predicated on these findings.

Therefore, the invention provides a solar cell electrode connection-providing sheet, a method for the manufacture of a solar cell module, and a solar cell module, as defined below.
[Claim 1]
   A solar cell electrode connection-providing sheet which is used when a power-extracting electrode of a solar cell and an interconnect member are connected via an electroconductive adhesive material by applying heat and pressure across them,
   said connection-providing sheet comprising a polymer sheet which is interposed between a heat/pressure member and the interconnect member upon use.
[Claim 2]
   The solar cell electrode connection-providing sheet of claim 1 wherein said polymer sheet comprises at least one component selected from a heat resistant resin, fluoro-rubber, and silicone rubber.
[Claim 3]
   The solar cell electrode connection-providing sheet of claim 2 wherein said heat resistant resin is at least one resin selected from a fluoroplastic and a polyamide resin, having a glass transition temperature of at least 200°C or a melting point of at least 300°C.
[Claim 4]
   The solar cell electrode connection-providing sheet of any one of claims 1 to 3 wherein said polymer sheet is reinforced with a cloth and/or fibers made of an inorganic material and/or a heat resistant resin.
[Claim 5]
   The solar cell electrode connection-providing sheet of any one of claims 1 to 4 wherein said polymer sheet contains a heat conductive filler comprising at least one inorganic material selected from the group consisting of metals, metal oxides, metal nitrides, metal carbides, metal hydroxides, and carbon allotropes.
[Claim 6]
   The solar cell electrode connection-providing sheet of any one of claims 1 to 5 wherein said polymer sheet is a silicone rubber sheet obtained by shaping a silicone rubber composition into a sheet and heat curing the sheet, said silicone rubber composition comprising
   (A) 100 parts by weight of a crosslinkable organopolysiloxane having an average degree of polymerization of at least 100,
   (B) 0 to 600 parts by weight of at least one heat conductive powder selected from the group consisting of metals, metal oxides, metal nitrides, metal carbides, metal hydroxides, and carbon allotropes,
   (C) 0 to 80 parts by weight of a carbon black powder,
   (D) 0 to 50 parts by weight of a reinforcing silica powder having a BET specific surface area of at least 50 m²/g, and
   (E) an effective amount of a curing agent.
[Claim 7]
   The solar cell electrode connection-providing sheet of claim 6 wherein the heat conductive powder as component (B) is blended in an amount of at least 5 parts by weight and is a metal silicon powder having an average particle size of 1 to 50 µm.
[Claim 8]
   The solar cell electrode connection-providing sheet of claim 7 wherein said metal silicon powder has a forcedly oxidized film formed on surfaces.
[Claim 9]
   The solar cell electrode connection-providing sheet of claim 6 wherein the heat conductive powder as component (B) is blended in an amount of at least 5 parts by weight and is a crystalline silicon dioxide powder having an average particle size of 1 to 50 µm.
[Claim 10]
   The solar cell electrode connection-providing sheet of any one of claims 6 to 9 wherein said silicone rubber sheet has an elongation at break of 40 to 1,000% and a type A Durometer hardness of 10 to 90, at 23°C.
[Claim 11]
   The solar cell electrode connection-providing sheet of any one of claims 1 to 10, having a heat conductivity of at least 0.3 W/mK.
[Claim 12]
   The solar cell electrode connection-providing sheet of claim 1 wherein sheets of at least two types selected from the polymer sheets of any one of claims 2 to 11 are stacked one on another.
[Claim 13]
   The solar cell electrode connection-providing sheet of any one of claims 1 to 12, having a thickness of 0.01 to 1 mm.
[Claim 14]
   The solar cell electrode connection-providing sheet of any one of claims 1 to 13 wherein said interconnect member is a strip-like electroconductive member.
[Claim 15]
   The solar cell electrode connection-providing sheet of any one of claims 1 to 14 wherein said interconnect member comprises at least one metal element selected from the group consisting of Cu, Ag, Au, Fe, Ni, Zn, Co, Ti, Pb, and Mg.
[Claim 16]
   The solar cell electrode connection-providing sheet of any one of claims 1 to 15 wherein said interconnect member is coated with a solder.
[Claim 17]
   The solar cell electrode connection-providing sheet of any one of claims 1 to 16 wherein said electroconductive adhesive material is an electroconductive resin adhesive comprising an insulating resin and electroconductive particles.
[Claim 18]
   The solar cell electrode connection-providing sheet of any one of claims 1 to 17 wherein said electroconductive adhesive material is in film form.
[Claim 19]
   The solar cell electrode connection-providing sheet of any one of claims 1 to 16 wherein said electroconductive adhesive material is a solder.
[Claim 20]
   The solar cell electrode connection-providing sheet of any one of claims 1 to 19 wherein said electroconductive adhesive material is formed on the interconnect member.
[Claim 21]
   A method for manufacturing a solar cell module, comprising the step of connecting a power-extracting electrode of a solar cell and an interconnect member via an electroconductive adhesive material by applying heat and pressure across them,
   said method further comprising the step of interposing the solar cell electrode connection-providing sheet of any one of claims 1 to 20 between a heat/pressure member and the interconnect member prior to the step of applying heat and pressure.
[Claim 22]
   A method for manufacturing a solar cell module, comprising the step of connecting front and back surface electrodes disposed on opposite surfaces of each solar cell for extracting power therefrom and interconnect members via an electroconductive adhesive material by applying heat and pressure across them,
   said method further comprising the steps of interposing the solar cell electrode connection-providing sheets of any one of claims 1 to 20 between heat/pressure members and the interconnect members and applying heat and pressure for simultaneously connecting the front and back surface electrodes and the interconnect members.
[Claim 23]
   A solar cell module comprising a single solar cell having an electrode for extracting power therefrom and an interconnect member connected to the electrode, which is manufactured by the method of claim 21 or 22.
[Claim 24]
   A solar cell module comprising a plurality of arranged solar cells as set forth in claim 23, wherein power-extracting electrodes of adjacent solar cells are connected by the interconnect member.

### Advantageous Effects of Invention

According to the invention, when a power-extracting electrode of a solar cell and an interconnect member are connected via an electroconductive adhesive material by applying heat and pressure across them, an optimized solar cell electrode connection-providing sheet comprising a polymer sheet is used after it is interposed between a heat/pressure member and the interconnect member. The components to be heated and pressed are press bondable on their entire surfaces at a uniform temperature and pressure. This enables a sure connection free of contact failure. A solar battery consisting of a single solar cell having high quality and long-term durability and a solar cell module having a plurality of such solar cells arranged and connected can be manufactured in a consistent manner and delivered to the market.

Particularly when an electroconductive resin adhesive comprising an insulating resin and electroconductive particles is used as the electroconductive adhesive material, a solar cell and a solar cell module which have overcome the warp and/or crack problem of solar cells can be manufactured in a consistent manner and delivered to the market. The invention is expected to be more effective in the future since solar cells are forecasted to be constructed in thinner film structure.
The solar cell electrode connection-providing sheet of the invention is also effective for preventing any electroconductive adhesive material squeezed outside upon press bonding from sticking to the heat/pressure member and preventing the electroconductive adhesive material from depositing on the heat/pressure member. Since the heat/pressure member is most often a hard metal member, the connection-providing sheet also plays the role of mitigating the impact from the heat/pressure member during press bonding for thereby preventing the solar cell from cracking.
Since the solar cell electrode connection-providing sheet of the invention is non-sticky to the interconnect member, electroconductive adhesive material, surface electrodes, and other members which are in contact with the sheet upon press bonding, repetitive press bonding is possible using an identical portion of the connection-providing sheet. A reliable connection is achievable as well as cost reduction and labor saving.

### BRIEF DESCRIPTION OF DRAWINGS

FIG. 1 is a cross-sectional view of a solar cell and connection-providing sheets used in Examples of the invention.
FIG. 2 illustrates one embodiment of connected solar cells, FIG. 2a being a plan view, FIG. 2b being a cross-sectional view, and FIG. 2c being an enlarged cross-sectional view of one solar cell.

### DESCRIPTION OF EMBODIMENTS

The electrode connection-providing sheet of the invention is used when a power-extracting electrode of a solar cell and an interconnect member are connected via an electroconductive adhesive material by applying heat and pressure across them. The electrode connection-providing sheet is characterized as a polymer sheet which is, on use, interposed between a heat/pressure member and the interconnect member and which preferably comprises at least one component selected from a heat resistant resin, fluoro-rubber, and silicone rubber.

### Type of solar cell

The type of the solar cell with which the solar cell electrode connection-providing sheet of the invention is used is not particularly limited as long as the cell has electrodes for extracting electric power therefrom. In terms of the material capable of generating power through photovoltaic conversion of sunlight, the solar cell is classified into silicon, compound, and organic systems. For example, the silicon systems include monocrystalline silicon, polycrystalline silicon, microcrystalline silicon, amorphous silicon, hybrid between crystalline silicon and amorphous silicon (known as heterojunction with intrinsic thin-layer, HIT), and other types. The compound systems include III-V Group systems like GaAs single crystal, I-III-V Group compounds known as copper-indium-selenide (CIS) or chalcopyrite, for example, Cu(In,Ga)Se₂, Cu(In,Ga)(Se,S)₂, and CuInS₂. which are referred to as CIGS, CIGSS, and CIS, respectively, and CdTe-CdS systems. The organic systems include dye sensitization and organic thin-film types. In terms of thickness, the solar cell is classified into relatively thick crystalline solar cells and thin-film solar cells having thin layers formed on glass or film.

### Press bonding

The shape of an electrode for extracting power from a solar cell may be, for example, a structure having formed thereon a collector electrode composed mainly of silver or the like, referred to as finger or bus-bar, or a collector electrode-free structure, but is not limited thereto.
The interconnect member is preferably a strip-like electroconductive member of flat rectangular shape in cross section, for example, which is preferably made of a material comprising at least one metal element selected from the group consisting of Cu, Ag, Au, Fe, Ni, Zn, Co, Ti, Pb, and Mg.
If necessary, an interconnect member coated with solder may be used.

The electroconductive adhesive material is preferably an electroconductive resin adhesive comprising an insulating resin and electroconductive particles. Although the adhesive may be used in paste form, a pre-formed film of the adhesive is preferably used because the manufacture process can be simplified. The adhesive may also be used after it is previously formed on an interconnect member. The insulating resin used in the electroconductive adhesive material may be selected from epoxy, acrylic, phenoxy, polyimide, silicone, urethane resins, and modified forms of the foregoing, a mixture of two or more of these resins being acceptable, but not limited thereto. Specifically, thermosetting epoxy resins and acrylic resins having acrylic rubber or butyl rubber incorporated therein, having a kinematic viscoelasticity of 1×10³ to 1×10¹⁰ Pa are useful. Also, solder may be used as the electroconductive adhesive material, if desired.

The electroconductive particles used in the resin adhesive are typically metallic particles including particles of Cu, Ag, Au, Fe, Ni, Zn, Co, Ti, Pb, Mg, and solder, and particles of styrene and other resins, glass, and silica which are surface plated with a metal selected from the foregoing. The particles preferably have an average particle size of 1 to 100 µm, more preferably 2 to 80 µm. It is noted that the average particle size may be determined as a cumulative weight average value D₅₀ or median diameter using a particle size distribution measuring meter by the laser diffraction method.

### Material and construction of solar cell electrode connection-providing sheet

The solar cell electrode connection-providing sheet of the invention must be heat resistant because it is often used in contact with a heat/pressure member of an interconnect member connecting apparatus which is typically heated at or above 300°C in order that the electroconductive resin adhesive material comprising an insulating resin and electroconductive particles be heat cured or the solder be melted. Therefore, the connection-providing sheet is preferably made of a heat resistant polymeric material. Specifically, the material of the sheet is at least one polymer selected from a heat resistant resin, fluoro-rubber, and silicone rubber. The preferred heat resistant resin is at least one resin selected from fluoroplastics and polyamide resins having a glass transition temperature of at least 200°C or a melting point of at least 300°C. Although the upper limit of glass transition temperature or melting point of the heat resistant resin is not critical, it is often preferably up to 500°C.

Examples of the fluoroplastic having a melting point of at least 300°C include, but are not limited to, polytetrafluoroethylene (PTFE), tetrafluoroethylene-perfluoroalkyl vinyl ether copolymers (PFA), polytrifluorochloroethylene (PTFCE), polyvinylidene fluoride (PVDF), and similar resins. Examples of the polyamide resin having a glass transition temperature of at least 200°C include, but are not limited to, aromatic polyimide, polyamideimide, aromatic polyamide, polyether sulfone, polyether imide, and similar resins. Also exemplary are resin-based sheets such as heat resistant sheets made of aramid fibers impregnated with such resins. Heat resistant fluoro-rubbers obtained by modifying the foregoing are also useful.

The solar cell electrode connection-providing sheet of the invention preferably has a relatively high heat conductivity because the sheet must conduct heat from the heat/pressure member to the electroconductive adhesive member. Since a polymeric material has a relatively low heat conductivity, a heat conductive filler of inorganic material is preferably added to the polymeric material to increase the heat conductivity of the sheet. The heat conductive filler of inorganic material is preferably at least one material selected from the group consisting of metals, metal oxides, metal nitrides, metal carbides, metal hydroxides, and carbon allotropes. The heat conductive filler of metal is preferably at least one metal powder selected from among metallic silicon, aluminum, gold, silver, copper, iron, nickel, and alloys thereof. Examples of the metal oxide used herein include zinc oxide, aluminum oxide, magnesium oxide, silicon dioxide, and iron oxide; examples of the metal nitride include boron nitride, aluminum nitride, and silicon nitride; examples of the metal carbide include silicon carbide and boron carbide; exemplary of the metal hydroxide is aluminum hydroxide; and examples of the carbon allotrope include various carbon fibers and graphite. The heat conductive filler is preferably blended in an amount of 10 to 3,000 parts by weight per 100 parts by weight of the polymeric material.

### Embodiment wherein solar cell electrode connection-providing sheet is silicone rubber

Described below is a silicone rubber composition for forming the silicone rubber used herein.

### [Composition]

Main properties that the solar cell electrode connection-providing sheet of the invention must possess include cushioning property, high-temperature press bondability, and heat conductivity. The silicone rubber is the preferred material of which the solar cell electrode connection-providing sheet of the invention is made because the silicone rubber is easy to adjust its elongation and hardness so as to have appropriate cushioning property, has satisfactory high-temperature press bondability, and may be increased in heat conductivity by adding a heat conductive filler.

Exemplary of the silicone rubber composition used herein is a composition comprising, in admixture,
(A) an organopolysiloxane having an average degree of polymerization of at least 100 and
(E) a curing agent, and optionally,
(B) at least one heat conductive powder selected from the group consisting of metals, metal oxides, metal nitrides, metal carbides, metal hydroxides, and carbon allotropes,
(C) a carbon black powder, and
(D) a reinforcing silica powder having a BET specific surface area of at least 50 m²/g.

Components (A) to (E) in the silicone rubber composition used herein are described.

### Component A

Component (A) used herein is a crosslinkable organopolysiloxane having an average degree of polymerization of at least 100, which typically has the following average compositional formula (1):

RₙSiO_{(4-n)/2} (1)

wherein n is a positive number of 1.9 to 2.4, and R is a substituted or unsubstituted monovalent hydrocarbon group.

Examples of the substituted or unsubstituted monovalent hydrocarbon group represented by R include alkyl groups such as methyl, ethyl and propyl, cycloalkyl groups such as cyclopentyl and cyclohexyl, alkenyl groups such as vinyl and allyl, aryl groups such as phenyl and tolyl, and halogenated hydrocarbon groups in which some or all hydrogen atoms on the foregoing groups are replaced by halogen atoms such as chlorine or fluorine.

The organopolysiloxane as component (A) preferably has a backbone consisting of dimethylsiloxane units or such a backbone in which an organic group such as methyl, vinyl, phenyl or trifluoropropyl is incorporated. It is preferred that vinyl account for 0.0001 to 10 mol% of the organic group and methyl account for at least 80 mol%. The organopolysiloxane capped with a triorganosilyl or hydroxyl group at the end of its molecular chain is preferred. Exemplary of the triorganosilyl group are trimethylsilyl, dimethylvinylsilyl, and trivinylsilyl.

The organopolysiloxane as component (A) may be used alone or a mixture of two or more may be used. The organopolysiloxane of formula (1) in which vinyl accounts for 0.10 to 0.50 mol% of the entire R in its molecule is preferred as component (A). Also the organopolysiloxane of formula (1) as component (A) should preferably have an average degree of polymerization of at least 100, more preferably at least 200. If the average degree of polymerization is less than 100, the cured composition may have poor mechanical strength. The upper limit of the average degree of polymerization is preferably up to 100,000, more preferably up to 50,000, though not critical. It is noted that the average degree of polymerization is determined by gel permeation chromatography (GPC) versus polystyrene standards.

### Component B

Component (B) is added for imparting heat conduction and used where a high heat conductivity is necessary. It is at least one heat conductive powder selected from the group consisting of metals, metal oxides, metal nitrides, metal carbides, metal hydroxides, and carbon allotropes, that is, a filler for imparting heat conduction to the silicone rubber sheet in one embodiment of the invention. Non-limiting examples of the metal include gold, silver, copper, iron, metal silicon, nickel, aluminum and alloys thereof; examples of the metal oxide include zinc oxide, aluminum oxide, magnesium oxide, silicon dioxide, and iron oxide; examples of the metal nitride include boron nitride, aluminum nitride, and silicon nitride; examples of the metal carbide include silicon carbide and boron carbide; a typical metal hydroxide is aluminum hydroxide; and examples of the carbon allotrope include various carbon fibers and graphite.

Of the foregoing heat conductive powders, metal silicon powder and crystalline silicon dioxide powder are especially preferred. Use of these powders may reduce compression molding strain, thereby minimizing degradation due to permanent deformation by repetitive press bonding. There is available a fully durable silicone rubber sheet for heat press bonding. Additionally, since both the powders have a low specific gravity, a silicone rubber sheet for heat press bonding may be given a lower specific gravity so that it may be easier to handle.

The shape of powder particles is not particularly limited and may be any of spherical, ellipsoidal, flat, flake, angular irregular, rounded irregular, and needle shapes. In the case of metal silicon, for example, spherical shape and irregular shape resulting from pulverizing are exemplary.

Although the purity of the heat conductive powder is not particularly limited, it is preferred from the standpoint of imparting heat conduction for the powder to have a purity of at least 50% by weight, more preferably at least 80% by weight, and even more preferably at least 95% by weight.

The method for preparing the metal silicon powder used herein is not particularly limited. Included are a silicon powder obtained by reducing silica stone into metal silicon and grinding the metal silicon on an existing crusher or grinder such as a ball mill, a silicon powder obtained by pulverizing a raw material such as metal silicon (wafer) or machining chips resulting from semiconductor manufacturing process or the like, a silicon powder powdered by any pulverizing method, and a spherical metal silicon powder such as spherical particles obtained by melting metal silicon at high temperature, atomizing the melt by a vapor phase technique, cooling and solidifying (the term "spherical" as used herein means that individual particles have a smooth shape free of pointed edges on their surface, typically having a length/breadth ratio (aspect ratio) from about 1.0 to about 1.4, preferably from about 1.0 to about 1.2). The crystal structure of metal silicon may be either monocrystalline or polycrystalline. Although the purity of the metal silicon powder in microparticulate form is not particularly limited, it is preferred from the standpoint of imparting heat conduction for the powder to have a purity of at least 50% by weight (i.e., 50 to 100% by weight), more preferably at least 80% by weight (i.e., 80 to 100% by weight), and even more preferably at least 95% by weight (i.e., 95 to 100% by weight). A metal silicon powder of high purity is thermally stable at high temperature because the spontaneously oxidized film on the surface is defect-free.
Such an oxide film may be provided, preferably by carrying out heat treatment at or above 100°C for at least 1 hour while pneumatically fluidizing the powder in a fluidized layer.

The metal silicon powder or crystalline silicon dioxide powder used herein as component (B) has an average particle size of up to 50 µm, preferably 1 to 50 µm, more preferably 1 to 25 µm, and even more preferably 2 to 25 µm. Particles with an average particle size of less than 1 µm may be difficult to prepare and to blend in a large amount, whereas particles with an average particle size in excess of 50 µm may not only detract from the mechanical strength of the cured rubber, but also be detrimental to the surface performance of the resulting sheet.

It is noted that the average particle size may be determined as a cumulative weight average value D₅₀ or median diameter using a particle size distribution measuring meter by the laser diffraction method or the like.

For the purposes of improving the thermal stability of the silicone rubber composition and the loading of the powder, the metal silicon powder as component (B) may be surface treated with a silane coupling agent or partial hydrolyzate thereof, alkylalkoxysilane or partial hydrolyzate thereof, organic silazane, titanate coupling agent, organopolysiloxane oil, hydrolyzable functional group-bearing organopolysiloxane or the like. As to the stage of treatment, the inorganic powder may be previously treated by itself or may be treated during mixing with component (A).

Component (B) may be blended herein in an amount of 0 to 600 parts by weight per 100 parts by weight of component (A) although it is preferably used in a range of 5 to 400 parts by weight. An amount in excess of 600 parts by weight may be difficult to blend, make molding and working inefficient, and reduce the strength of the sheet.

### Component C

Component (C) used herein is carbon black powder, which is used when it is desired to improve the mechanical strength, particularly at elevated temperature, of a silicone rubber sheet for enhancing the heat resistance thereof and to make the sheet thermally conductive and electrically conductive for imparting antistatic property thereto.

Carbon black is divided into furnace black, channel black, thermal black, acetylene black and the like, in accordance with the preparation method. Many carbon blacks typically contain impurities such as sulfur. Herein carbon black with a volatile content (exclusive of water) of up to 0.5% by weight is preferably used. Acetylene black is most preferred because of minimal impurities.
The method of measuring a volatile content (exclusive of water) is described in JIS K6221 "Method of testing carbon black for rubber use." Specifically, a predetermined amount of carbon black is placed in a crucible and heated at 950°C for 7 minutes, after which a volatility loss is measured.

The carbon black as component (C) preferably has an average particle size in the range of 10 to 300 nm, more preferably 15 to 100 nm. The carbon black preferably has a BET specific surface area of 20 to 300 m²/g, more preferably 30 to 200 m²/g. The shape of carbon black may be either particulate or acicular.

The average particle size of carbon black is an average particle size on electron microscopic analysis, specifically obtained by taking a photomicrograph under electron microscope, measuring the diameter of primary particles on the micrograph, and calculating an arithmetic average thereof. It is understood that primary particles of carbon black typically agglomerate together to form secondary particles. As used herein, the "average particle size" refers to that of primary particles rather than that of secondary particles.

Component (C) may be blended herein in an amount of 0 to 80 parts by weight per 100 parts by weight of component (A) although it is preferably used in a range of 5 to 75 parts by weight. An amount in excess of 80 parts by weight may be difficult to blend uniformly and result in a composition which is awkward to shape and work.

### Component D

Component (D) used herein is a reinforcing silica powder having a BET specific surface area of at least 50 m²/g. Examples include hydrophilic or hydrophobic fumed silica (dry silica), precipitated silica (wet silica), crystalline silica, and quartz, which may be used alone or in a combination of two or more. For reinforcement, fumed silica and precipitated silica should preferably have a BET specific surface area of at least 50 m²/g although it is often preferred to use silica having a surface area of about 50 to 800 m²/g, especially about 100 to 500 m²/g. A specific surface area of less than 50 m²/g may fail to achieve the desired reinforcing effect.

Of these silica species, examples of commercially available hydrophilic silica include, but are not limited to, Aerosil 130, 200 and 300 (trade name by Nippon Aerosil Co., Ltd. or Degussa), Cabosil MS-5 and MS-7 (trade name by Cabot), Rheorosil QS-102 and 103 (trade name by Tokuyama Co., Ltd.), and Nipsil LP (trade name by Nippon Silica Co., Ltd.). Examples of hydrophobic silica include, but are not limited to, Aerosil R-812, R-812S, R-972 and R-974 (trade name by Degussa), Rheorosil MT-10 (trade name by Tokuyama Co., Ltd.), and Nipsil SS series (trade name by Nippon Silica Co., Ltd.).

Component (D) may be blended herein in an amount of 0 to 50 parts by weight per 100 parts by weight of component (A) although it is preferably used in a range of 5 to 35 parts by weight, more preferably 10 to 30 parts by weight. If the amount is more than 50 parts by weight, a silicone rubber composition may have too high a plasticity to shape or a cured rubber may become too hard.

### Component E

Component (E) used herein is a curing agent. A choice may be made from well-known curing agents commonly used in the curing of silicone rubber. Examples of such curing agents include
(a) organic peroxides used in radical reaction, such as di-t-butyl peroxide, 2,5-dimethyl-2,5-di(t-butylperoxy)-hexane, and dicumyl peroxide, and
(b) a combination of an organohydrogenpolysiloxane containing at least two silicon-bonded hydrogen atoms in a molecule with a platinum group metal base catalyst such as platinum or palladium, as the addition reaction curing agent where the organopolysiloxane as component (A) has alkenyl groups. In the practice of the invention, preference is given to the addition reaction curing agent (b) for the reason that reaction control is easy and no reaction residues are left behind, although a mixture of both may be used if necessary.

Although the amount of the curing agent added may be the same as in the case of conventional silicone rubber, it is generally determined as follows.
The curing agent (a) is preferably used in an amount of 0.1 to 20 parts by weight per 100 parts by weight of the organopolysiloxane as component (A).
For the curing agent (b), it is preferred that the organohydrogenpolysiloxane having at least two silicon-bonded hydrogen atoms per molecule is used in such an amount that 0.5 to 5 moles of silicon-bonded hydrogen atom on the organohydrogenpolysiloxane are available per mole of alkenyl group in component (A), and the platinum group metal based catalyst is used in such an amount as to provide 0.1 to 1,000 ppm of metal value based on the weight of component (A).

### Other components

To the silicone rubber composition used herein, heat resistance improvers such as cerium oxide, red iron oxide, and titanium oxide, fillers such as clay, calcium carbonate, diatomaceous earth, and titanium dioxide, dispersants such as low-molecular-weight siloxane esters and silanols, tackifiers such as silane coupling agents and titanium coupling agents, platinum group metal compounds for imparting flame retardance, and reinforcements for increasing the green strength of rubber compound such as tetrafluoropolyethylene particles, glass fibers and aramid fibers may be added if necessary.

### Preparation and Processing

The silicone rubber composition used herein may be prepared by kneading the aforementioned components on a mixer such as a two-roll mill, kneader, Banbury mixer or planetary mixer. In general, it is preferred to pre-mix all the components other than the curing agent so that only the curing agent may be added immediately before use.
The method for shaping a silicone rubber sheet serving as the solar cell electrode connection-providing sheet of the invention may be a method of sheeting a silicone rubber composition having mixed all the components including the curing agent by means of a calendering or extruding machine to a predetermined thickness, followed by curing, a method of coating a film with a liquid silicone rubber composition or a silicone rubber composition liquefied by dissolving in a solvent such as toluene, followed by curing, or the like.

### Silicone rubber's properties

To ensure that a silicone rubber sheet has adequate cushioning property, the cured silicone rubber composition should preferably have an elongation at break and a hardness as specified below.
The elongation at break at room temperature or 23°C is preferably 40 to 1,000%, more preferably 60 to 300%, and even more preferably 70 to 150%. As the general rule, a lower elongation is better in order to avoid any displacement of the connection-providing member. An elongation of less than 40% means that the sheet lacks flexibility so that the sheet cannot conform to any irregularities or steps in a portion to be press bonded, resulting in a failure of press bonding under a uniform pressure and a failure of stress dispersion. This gives rise to a problem that the sheet is likely to tear, or the sheet is broken when a force is applied to the sheet in a folding direction.

The hardness at room temperature or 23°C as measured by type A Durometer is preferably 10 to 90, more preferably 40 to 85. A hardness in this range not only prevents any displacement, but also ensures sufficient cushioning property to correct any tolerance of planarity, flatness or parallelism of a component to be press bonded to convey a uniform pressure.

### Reinforcement

The solar cell electrode connection-providing sheet of the invention may be reinforced with a cloth and/or fibers made of an inorganic material and/or a heat resistant resin. For example, fibers of inorganic material include glass fibers, carbon fibers, and stainless steel fibers, and fibers of heat resistant resin include aramid fibers, amide fibers, and fluoroplastic fibers such as polytetrafluoroethylene, but are not limited thereto. Reinforcement may be achieved by admixing such fibers in the polymer, or by knitting such fibers to form a cloth and laying the cloth as an intermediate layer or on one side, although the reinforcing method is not limited thereto. The reinforcement with fibrous material restrains the sheet from elongation in the plane direction, enables to convey the pressure from the heat/pressure member of an interconnect member connection apparatus to the electroconductive adhesive member, and significantly improves resistance against breakage.

Upon application of heat and pressure, the solar cell electrode connection-providing sheet of the invention is in direct contact with the heat/pressure member of an interconnect member connection apparatus, interconnect member, squeezed electroconductive adhesive material, and the like. The electroconductive adhesive material used herein is an adhesive material comprising an insulating resin and electroconductive particles or a solder. Since the solar cell electrode connection-providing sheet is used during hot press bonding and thus often exposed to high temperatures of at least 300°C, the sheet may stick to the members in direct contact, with the risk of breakage. Therefore the sheet should preferably be non-detrimental and non-sticky to the members in direct contact with its surface.

### Heat conductivity of solar cell electrode connection-providinq sheet

The solar cell electrode connection-providing sheet of the invention plays the role of conducting the heat from the heat/pressure member of an interconnect member connection apparatus to the electroconductive adhesive material. From this aspect, the sheet preferably has a higher heat conductivity. The heat conductivity at room temperature or 23°C is preferably at least 0.3 W/mK, more preferably at least 0.4 W/mK, and even more preferably at least 0.6 W/mK. With a heat conductivity of less than 0.3 W/mK, little heat is conducted to the electroconductive adhesive material, and hence, the temperature of the heat/pressure member must be further elevated. Elevating the temperature of the heat/pressure member imposes a heavier load to the interconnect member connection apparatus, sometimes canceling the cost merits of the connection method of the invention. Also, since the heat/pressure member at higher temperature contacts with the solar cell electrode connection-providing sheet, the thermal degradation of the sheet may be promoted. Further, the heat/pressure member at higher temperature gives radiant heat to the electroconductive electrode film on the semiconductor device, which may give rise to a problem to the solar cell. On the other hand, if the heat conductivity exceeds 5 W/mK, blending the heat conductive powder to such an extent is difficult, and the sheet has too weak a strength to use. The heat conductivity is preferably up to 5 W/mK.

### Laminate

The solar cell electrode connection-providing sheet of the invention may have a laminate structure of two or more stacked sheet layers of different composition, selected from the solar cell electrode connection-providing sheets of the invention. An exemplary laminate sheet is of at least two layers, for example, of polyimide and silicone rubber, polytetrafluoroethylene and silicone rubber, glass cloth coated with polytetrafluoroethylene and silicone rubber, at least two silicone rubber layers of different composition, fluoro-rubber and silicone rubber, or the like, although examples are not limited thereto. Also, in one non-limiting example, a sheet reinforced with a cloth and/or fibers of inorganic material and/or heat resistant resin may be laminated with a non-reinforced sheet. Lamination may take advantage of the respective sheets.

### Thickness of solar cell electrode connection-providing sheet

The solar cell electrode connection-providing sheet of the invention preferably has a thickness of 0.01 to 1 mm. When the sheet is made of heat resistant resin, a thickness in the range of 0.01 to 0.5 mm is preferred, with the range of 0.02 to 0.2 mm being more preferred. A sheet with a thickness of less than 0.01 mm may be too weak in strength, fragile, and awkward to handle. On the other hand, a sheet with a thickness of more than 0.5 mm may be less effective in heat transfer. When the sheet is made of fluoro-rubber or silicone rubber, a thickness in the range of 0.05 to 1 mm is preferred, with the range of 0.1 to 0.5 mm being more preferred. A sheet with a thickness of less than 0.05 mm may have insufficient cushioning property, failing to convey uniform pressure. On the other hand, a sheet with a thickness of more than 1 mm may be less effective in heat transfer.
When the solar cell electrode connection-providing sheet of the invention is as thin as 0.01 to 0.2 mm, a heat conductivity of at least 0.3 W/mK is not necessarily needed for the reason that a necessary heat transfer capability in sheet thickness direction is sometimes available even if its heat conductivity is less than 0.3 W/mK.

### Connecting method

The method for connecting a solar cell electrode according to the invention involves the step of connecting a power-extracting electrode of a solar cell and an interconnect member via an electroconductive adhesive material by applying heat and pressure across them, wherein the solar cell electrode connection-providing sheet of the invention is interposed between a heat/pressure member of an interconnect member connecting apparatus and the interconnect member prior to the step of applying heat and pressure.
The electroconductive adhesive material may be applied in either way, for example, by separately preparing a film or paste material comprising an insulating resin and electroconductive particles and disposing the film or paste material on the power-extracting electrode of the solar cell prior to the connecting step, or by previously shaping the electroconductive adhesive material on the interconnect member. The embodiment using the interconnect member having the electroconductive adhesive material previously shaped thereon is effective for shortening the connecting step. In the other embodiment using the solder-plated interconnect member, the plated solder may be utilized as the electroconductive adhesive material, eliminating a need for providing a separate electroconductive adhesive material. In the other embodiment using the solder-plated interconnect member, connection may be achieved under such conditions that the solder may not melt, using a separate electroconductive adhesive material comprising an insulating resin and electroconductive particles; or both the plated solder and the electroconductive adhesive material comprising an insulating resin and electroconductive particles may function as the electroconductive adhesive material whereby they complete the connection in a combined manner.

Since the optimized solar cell electrode connection-providing sheet of the invention is, on use, interposed between the heat/pressure member and the interconnect member, the connecting method of the invention can achieve press bonding at a uniform temperature and pressure over the entire surface of the heat/pressure member, prevent the squeezed-out electroconductive adhesive material from sticking to the heat/pressure member, and prevent the electroconductive adhesive material from depositing on the heat/pressure member. Also, since the heat/pressure member is typically a hard member made of metal, the connection-providing sheet plays the role of mitigating the impact of the heat/pressure member during press bonding for preventing the solar cell from cracking.

The conditions under which the solar cell electrode is connected according to the invention are optimized depending on the type and structure of solar cell and a particular electroconductive adhesive material compatible therewith. With respect to typical conditions employed where the electroconductive resin adhesive material comprising an insulating resin and electroconductive particles is used, the electroconductive resin adhesive material is heated at a temperature of 130 to 220°C, the heat/pressure member is set at a temperature of 200 to 400°C and a pressure of 1 to 5 MPa, and the press bonding time is 3 to 30 seconds. However, the conditions are not limited to these ranges.

With respect to the connection of the solar cell electrode and the interconnect member, individual electrodes and interconnect members may be independently connected. In the case of a solar cell provided with front and back surface electrodes for extracting power therefrom, the mode of simultaneously applying heat and pressure across the front surface electrode and an interconnect member and across the back surface electrode and another interconnect member is preferred because of improved production efficiency.

### Solar cell module

The solar cell module of the invention is defined as comprising a single solar cell or an arrangement of plural solar cells, each cell having an electrode for extracting power therefrom, the power-extracting electrodes of adjacent solar cells and an interconnect member are connected by the solar cell electrode connecting method of the invention.

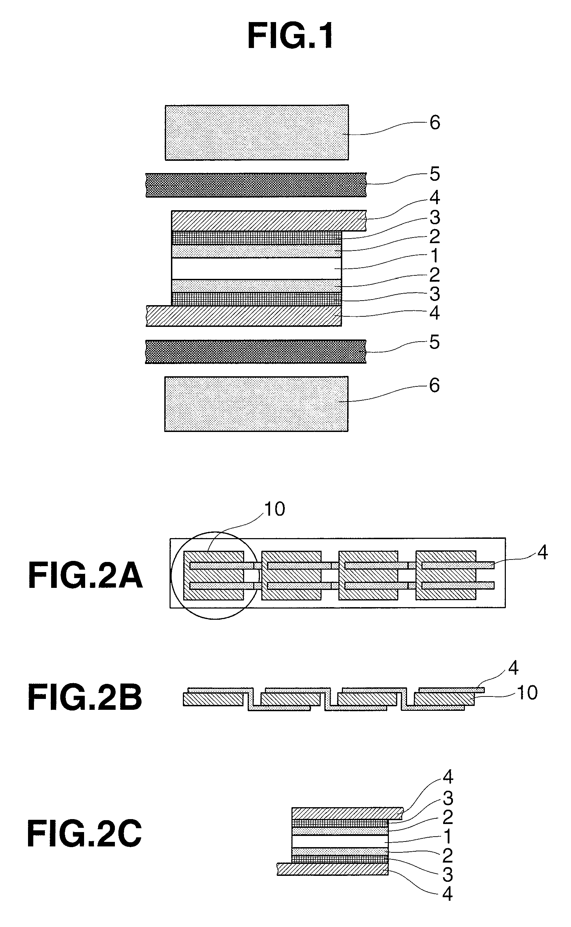

The solar cell module of the invention is manufactured through the step of connecting a power-extracting electrode of a solar cell and an interconnect member via an electroconductive adhesive material by applying heat and pressure across them, wherein the optimized solar cell electrode connection-providing sheet is interposed between a heat/pressure member and the interconnect member. The solar cell module of the invention has a structure as shown in FIG. 2, for example. FIG. 2a is a plan view of one exemplary arrangement of solar cells (a portion of a solar cell module), FIG. 2b is a cross-sectional view, and FIG. 2c is an enlarged cross-sectional view of one solar cell. A solar cell is depicted at 10 while a silicon substrate 1, electrodes 2, electroconductive adhesive material layers 3, and interconnect members 4 are illustrated.
The invention enables press bonding at a uniform temperature and pressure over the entire surface of a portion to be heated and pressed, yielding a solar cell module which is free of contact failure and has high quality and long-term durability. Particularly when a material comprising an insulating resin and electroconductive particles is used as the conductive adhesive material, a solar cell free of warp and cracks can be manufactured.

### EXAMPLE

Examples and Comparative Examples are given below for illustrating the invention although the invention is not limited thereto.

### Examples 1 to 6

A solar cell electrode connection-providing sheet was prepared by blending the following components in the formulation (parts by weight) shown in Table 1.

### (A) Organopolysiloxane

(a-1) methylvinylpolysiloxane consisting of 99.85 mol% of dimethylsiloxane units and 0.15 mol% of methylvinylsiloxane units, capped at both ends of the molecular chain with dimethylvinylsiloxy group, and having an average degree of polymerization of 8,000
(a-2) methylvinylpolysiloxane consisting of 99.5 mol% of dimethylsiloxane units and 0.5 mol% of methylvinylsiloxane units, capped at both ends of the molecular chain with dimethylvinylsiloxy group, and having an average degree of polymerization of 8,000

### (B) Heat conductive filler

(b-1) metal silicon ground powder having an average particle size of 5 µm (forced oxidizing treatment on surface)
(b-2) crystalline silicon dioxide ground powder having an average particle size of 4 µm
(b-3) aluminum oxide ground powder having an average particle size of 4 µm

### (C) Carbon black powder

(c-1) acetylene black having an average particle size of 35 nm, a volatile content (exclusive of water) of 0.10 wt%, and a BET specific surface area of 69 m²/g

### (D) Reinforcing silica fine powder

(d-1) reinforcing silica fine powder having a BET specific surface area of 300 m²/g (trade name: Aerosil 300 by Nippon Aerosil Co., Ltd.)

### (E) Curing agent

(e-1) chloroplatinic acid-vinylsiloxane complex (platinum content 1 wt%)
(e-2) methylhydrogenpolysiloxane having formula (1) 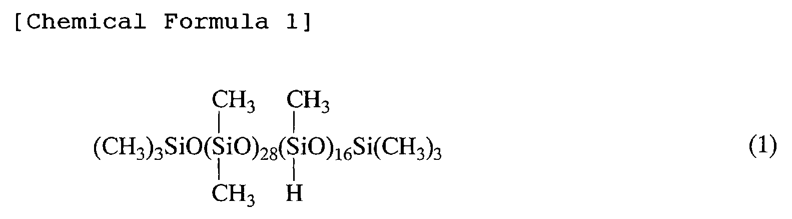
(e-3) organic peroxide: C-8 (by Shin-Etsu Chemical Co., Ltd.)
(e-4) organic peroxide: C-23 (by Shin-Etsu Chemical Co., Ltd.) Other components
(f-1) dimethyldimethoxysilane
(g-1) cerium oxide powder having a BET specific surface area of 140 m²/g
(h-1) ethynyl cyclohexanol

### Preparation and shaping of composition

A composition was prepared and shaped into a sheet as follows.
When component (D) was used, component (A), component (D), component (f-1) serving as a surface treating agent for component (D), and deionized water were blended and kneaded on a kneader while heating at 170°C for 2 hours, until the premix became uniform. When component (D) was absent, this step was unnecessary.
To the resulting premix or component (A) were added components (B) and (C) and optional component (g-1). On a pressure kneader, the contents were blended and kneaded for 15 minutes until uniform.
In the case of addition reaction cure type, a curable silicone rubber composition was prepared by adding components (e-1), (h-1) and (e-2) to the blend on a two-roll mill in the described order while continuing mill kneading. In the case of radical reaction cure type, a curable silicone rubber composition was prepared by adding component (e-3) or (e-4) to the blend and kneading on a two-roll mill.
Using a calendering machine, the resulting curable silicone rubber composition was sheeted to a thickness of 0.25 mm and transferred onto a polyethylene terephthalate (PET) film of 100 µm thick. The sheet form of silicone rubber composition was cured by passing the laminate of the silicone rubber composition and the PET film through a heating furnace for 5 minutes at 150°C in the case of addition reaction cure type or at 160°C in the case of radical reaction cure type. The sheet form of silicone rubber composition was peeled from the PET film and heat treated in a dryer at 200°C for 4 hours, yielding a silicone rubber sheet having a thickness of 0.20 to 0.45 mm.

### [Evaluation of basic physical properties of silicone rubber sheet]

Hardness and elongation at break were measured according to the test of JIS K6249. Hardness was measured by type A Durometer after sheets were stacked to a thickness of at least 6 mm. Elongation at break was measured using a dumbbell No. 2 specimen.
Also, heat conductivity was measured according to the test of ASTM E1530.
The results are shown in Table 1.

**Table 1**

| | | Example 1 | Example 2 | Example 3 | Example 4 | Example 5 | Example 6 |
|---|---|---|---|---|---|---|---|
| Blending formulation (parts by weight) | a-1 | 60 | - | 100 | 60 | 20 | 20 |
| | a-2 | 40 | 100 | - | 40 | 80 | 80 |
| | b-1 | 130 | - | - | - | - | - |
| | b-2 | - | 140 | - | - | - | 20 |
| | b-3 | - | - | 300 | - | - | - |
| | c-1 | 10 | 50 | - | 60 | - | - |
| | d-1 | 20 | - | 30 | - | 30 | 10 |
| | f-1 | 3 | - | 3 | - | 3 | 1 |
| | g-1 | 0.5 | 0.5 | 0.5 | 0.5 | 0.5 | - |
| | Deionized water | 1 | - | | 1 - | 1 | - |
| Amount of component blended per 100 parts by weight of the above compound (parts by weight) | e-1 | 0.05 | 0.1 | - | 0.1 | 0.1 | 0.1 |
| | e-2 | 0.7 | 1 | - | 1.5 | 2 | 2 |
| | e-3 | 0.5 | - | - | - | - | - |
| | e-4 | - | - | 1.5 | - | - | - |
| | h-1 | 0.025 | 0.04 | - | 0.05 | 0.05 | 0.05 |
| Thickness (mm) | | 0.25 | 0.35 | 0.45 | 0.25 | 0.20 | 0.20 |
| Hardness, type A Durometer | | 70 | 72 | 70 | 65 | 60 | 50 |
| Elongation at break (%) | | 90 | 60 | 100 | 130 | 150 | 180 |
| Heat conductivity (W/mK) | | 0.8 | 0.8 | 0.8 | 0.5 | 0.2 | 0.2 |

Using the silicone rubber sheets obtained in Examples 1 to 6 and the sheets obtained in Examples 7 to 11 and Comparative Examples 2 and 3 and solar cells, the following connection test was carried out for evaluation. The results are shown in Table 2.

### Example 7

A monolayer PTFE film of 130 µm thick: Nitoflon^{®} film (trade name of Nitto Denko Corp., m.p. 327°C, heat conductivity 0.2 W/mK) was used.

### Example 8

A glass cloth-reinforced PTFE film of 45 µm thick: Nitoflon^{®}-impregnated glass cloth (trade name of Nitto Denko Corp., m.p. 327°C, heat conductivity 0.3 W/mK) was used.

### Example 9

A polyimide film of 50 µm thick: Kapton 200H (trade name of Dupont-Toray Co., Ltd., melting point and glass transition temperature nil, heat conductivity 0.2 W/mK) was used.

### Example 10

By using a glass cloth-reinforced PTFE film of 45 µm thick in Example 8 instead of the PET film, and heat curing a silicone rubber layer of the composition of Example 1 onto the plasma-treated surface of the glass cloth-reinforced PTFE film to form a laminate, there was prepared a composite sheet of two-layer structure in which the glass cloth-reinforced PTFE film and the silicone rubber layer were stacked, having a total thickness of 0.25 mm.
A connection test was carried out with the surface of the glass cloth-reinforced PTFE film facing the solar cell side.

### Example 11

By shaping the composition of Example 1 into a layer of 0.25 mm thick, and stacking the composition of Example 6 thereon as a layer of 0.1 mm thick, a sheet having a total thickness of 0.35 mm was prepared.
A connection test was carried out with the layer of the composition of Example 6 facing the solar cell side.

### Comparative Example 1

A connection test was carried out without using the sheet.

### Comparative Example 2

An aluminum foil of 50 µm thick was used.

### Comparative Example 3

A glass cloth of 130 µm thick was used.

### [Connection test]

Silicon polycrystalline solar cells of 150 mm wide × 150 mm long × 160 µm thick provided with front and rear surface electrodes in the form of silver-based bus-bar collector electrodes of 2 mm wide were prepared as the power-extracting electrode.
A strip-like copper foil conductor in flat rectangular cross-sectional shape of 2 mm wide × 160 µm thick and a strip-like solder plated copper foil conductor obtained by solder plating the copper foil conductor were prepared as the interconnect member.
By shaping a composition comprising an epoxy-based insulating adhesive and gold-plated nickel particles having an average particle size of 6 µm, a film of 2 mm wide × 45 µm thick was prepared as the electroconductive adhesive material.

Further, the sheets of Examples 1 to 11 and Comparative Examples 2 and 3 shown in Table 2 were prepared as the solar cell electrode connection-providing sheet. Using the sheets, the front and rear surface electrodes of the silicon polycrystalline solar cells were connected to the interconnect members.
In Comparative Example 1, connection was performed without using the sheets.

Connection was performed by using an interconnect member connecting apparatus capable of simultaneously providing connection of front and rear surface electrodes on opposite surfaces. As shown in FIG. 1, each film 3 of the electroconductive adhesive material was interposed between an electrode 2 on a silicon substrate 1 and an interconnect member 4, electrode connection-providing sheets 5 were placed on the interconnect members 4, heat/pressure members 6 of the apparatus were placed thereon, whereby heat and pressure were applied by the apparatus. The press bonding conditions included the temperature of the heat/pressure members which was adjusted such that the electroconductive adhesive material was heated at 190°C, 3 MPa and 10 seconds. The surface temperature of the heat/pressure members was in excess of 300°C independent of the identity of the sheet used and independent of whether or not the sheet was used.

### [Evaluated items of connection test]

(1) Evaluation of uniformity of connection
A section of an overall connection of 150 mm long extending the overall length of the solar cell was observed under a microscope and examined for uniformity and defectives. The solder-plated copper foil conductor was used.
(2) Pass rate of connection resistance
For the sheet of one type, connections of interconnect members to electrodes of 100 solar cells were formed. Each connection between the electrode and the interconnect member was examined whether or not its electrical resistance was at an acceptable level. A pass rate was evaluated. The copper foil conductor was used.
(3) Percent occurrence of cell crack
For the sheet of one type, connections of interconnect members to electrodes of 100 solar cells were formed. A percentage of cracked cells was evaluated. The copper foil conductor was used.
(4) Evaluation of surface stain of heat/pressure member of apparatus
For the sheet of one type, connections of interconnect members to electrodes of 100 solar cells were formed. The surface of the heat/pressure member was examined for stains. The solder-plated copper foil conductor was used.
(5) Evaluation of non-sticking of solar cell electrode connection-providing sheet to members
Connection operation was repeated 10 times while an identical portion of the sheet of one type was repeatedly used, and the sheet was placed in direct contact with each of the following members. It was evaluated whether or not the sheet stuck to the member.

| | |
|---|---|
| Non-stickiness 1: | copper foil conductor as interconnect member |
| Non-stickiness 2: | solder-plated copper foil conductor as interconnect member |
| Non-stickiness 3: | silver-based bus-bar collector electrode on cell surface |
| Non-stickiness 4: | electroconductive adhesive film of epoxy-based insulating adhesive with gold-plated nickel particles having an average particle size of 6 µm compounded therein |

(6) Evaluation of surface state of solar cell electrode connection-providing sheet
Connection operation of interconnect members to electrodes was carried out on 10 solar cells while an identical portion of the sheet of one type was repeatedly used. The sheet was visually observed and evaluated for surface states including flaw and luster. The copper foil conductor was used.

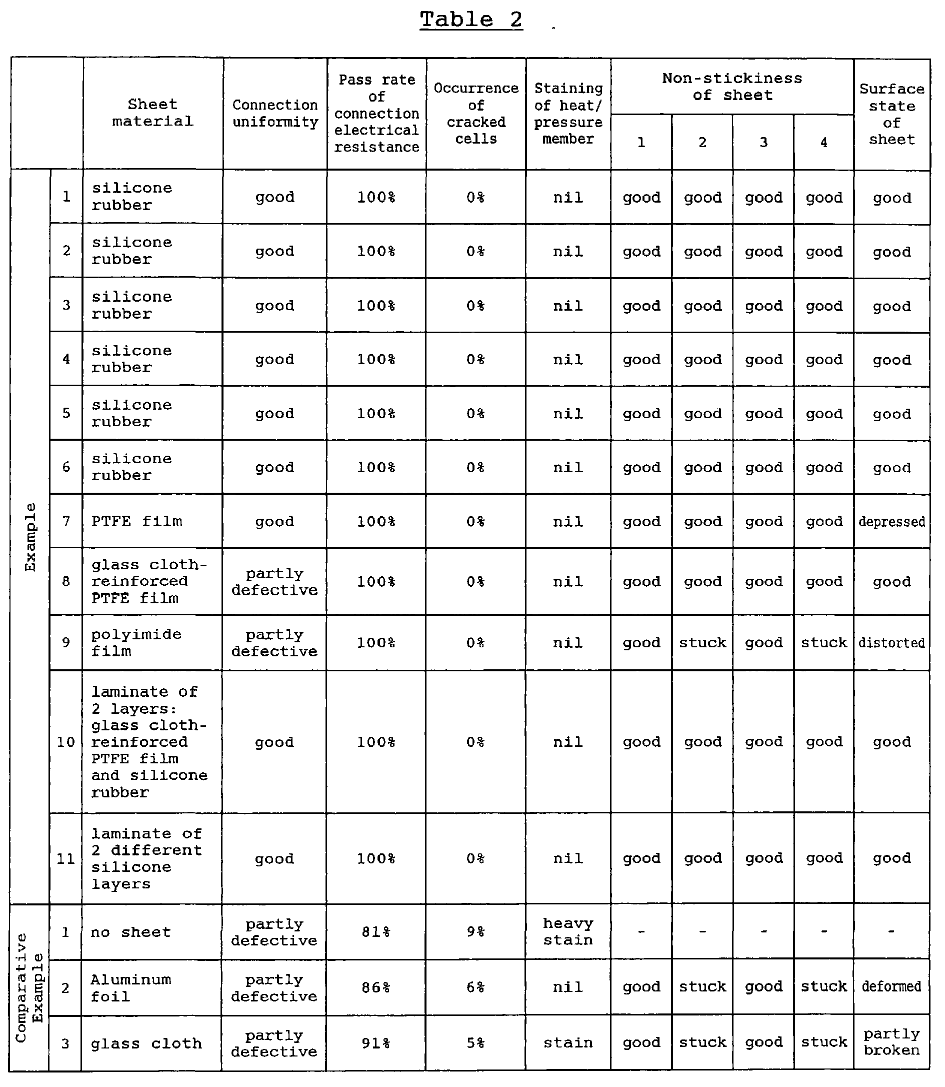

When solar cell electrodes and interconnect members are connected via an electroconductive adhesive material by using the inventive solar cell electrode connection-providing sheets of Examples 1 to 11 and applying heat and pressure, the entire surfaces subject to heat and pressure can be press bonded at a uniform temperature and pressure. This ensures a sure connection without contact failure and prevents the cells from cracking. In particular, the optimized silicone rubber sheet and laminate thereof undergo little degradation and exhibit satisfactory durability.

### LEGEND

- 1: silicon substrate
- 2: electrode
- 3: electroconductive adhesive material
- 4: interconnect member
- 5: electrode connection-providing sheet
- 6: heat/pressure member
- 10: solar cell

## Claims

1. A solar cell electrode connection-providing sheet which is used when a power-extracting electrode of a solar cell and an interconnect member are connected via an electroconductive adhesive material by applying heat and pressure across them,
said connection-providing sheet comprising a polymer sheet which is interposed between a heat/pressure member and the interconnect member upon use.

2. The solar cell electrode connection-providing sheet of claim 1 wherein said polymer sheet comprises at least one component selected from a heat resistant resin, fluoro-rubber, and silicone rubber.

3. The solar cell electrode connection-providing sheet of claim 2 wherein said heat resistant resin is at least one resin selected from a fluoroplastic and a polyamide resin, having a glass transition temperature of at least 200°C or a melting point of at least 300°C.

4. The solar cell electrode connection-providing sheet of any one of claims 1 to 3 wherein said polymer sheet is reinforced with a cloth and/or fibers made of an inorganic material and/or a heat resistant resin.

5. The solar cell electrode connection-providing sheet of any one of claims 1 to 4 wherein said polymer sheet contains a heat conductive filler comprising at least one inorganic material selected from the group consisting of metals, metal oxides, metal nitrides, metal carbides, metal hydroxides, and carbon allotropes.

6. The solar cell electrode connection-providing sheet of any one of claims 1 to 5 wherein said polymer sheet is a silicone rubber sheet obtained by shaping a silicone rubber composition into a sheet and heat curing the sheet, said silicone rubber composition comprising
(A) 100 parts by weight of a crosslinkable organopolysiloxane having an average degree of polymerization of at least 100,
(B) 0 to 600 parts by weight of at least one heat conductive powder selected from the group consisting of metals, metal oxides, metal nitrides, metal carbides, metal hydroxides, and carbon allotropes,
(C) 0 to 80 parts by weight of a carbon black powder,
(D) 0 to 50 parts by weight of a reinforcing silica powder having a BET specific surface area of at least 50 m²/g, and
(E) an effective amount of a curing agent.

7. The solar cell electrode connection-providing sheet of claim 6 wherein the heat conductive powder as component (B) is blended in an amount of at least 5 parts by weight and is a metal silicon powder having an average particle size of 1 to 50 µm.

8. The solar cell electrode connection-providing sheet of claim 7 wherein said metal silicon powder has a forcedly oxidized film formed on surfaces.

9. The solar cell electrode connection-providing sheet of claim 6 wherein the heat conductive powder as component (B) is blended in an amount of at least 5 parts by weight and is a crystalline silicon dioxide powder having an average particle size of 1 to 50 µm.

10. The solar cell electrode connection-providing sheet of any one of claims 6 to 9 wherein said silicone rubber sheet has an elongation at break of 40 to 1,000% and a type A Durometer hardness of 10 to 90, at 23°C.

11. The solar cell electrode connection-providing sheet of any one of claims 1 to 10, having a heat conductivity of at least 0.3 W/mK.

12. The solar cell electrode connection-providing sheet of claim 1 wherein sheets of at least two types selected from the polymer sheets of any one of claims 2 to 11 are stacked one on another.

13. The solar cell electrode connection-providing sheet of any one of claims 1 to 12, having a thickness of 0.01 to 1 mm.

14. The solar cell electrode connection-providing sheet of any one of claims 1 to 13 wherein said interconnect member is a strip-like electroconductive member.

15. The solar cell electrode connection-providing sheet of any one of claims 1 to 14 wherein said interconnect member comprises at least one metal element selected from the group consisting of Cu, Ag, Au, Fe, Ni, Zn, Co, Ti, Pb, and Mg.

16. The solar cell electrode connection-providing sheet of any one of claims 1 to 15 wherein said interconnect member is coated with a solder.

17. The solar cell electrode connection-providing sheet of any one of claims 1 to 16 wherein said electroconductive adhesive material is an electroconductive resin adhesive comprising an insulating resin and electroconductive particles.

18. The solar cell electrode connection-providing sheet of any one of claims 1 to 17 wherein said electroconductive adhesive material is in film form.

19. The solar cell electrode connection-providing sheet of any one of claims 1 to 16 wherein said electroconductive adhesive material is a solder.

20. The solar cell electrode connection-providing sheet of any one of claims 1 to 19 wherein said electroconductive adhesive material is formed on the interconnect member.

21. A method for manufacturing a solar cell module, comprising the step of connecting a power-extracting electrode of a solar cell and an interconnect member via an electroconductive adhesive material by applying heat and pressure across them,
said method further comprising the step of interposing the solar cell electrode connection-providing sheet of any one of claims 1 to 20 between a heat/pressure member and the interconnect member prior to the step of applying heat and pressure.

22. A method for manufacturing a solar cell module, comprising the step of connecting front and back surface electrodes disposed on opposite surfaces of each solar cell for extracting power therefrom and interconnect members via an electroconductive adhesive material by applying heat and pressure across them,
said method further comprising the steps of interposing the solar cell electrode connection-providing sheets of any one of claims 1 to 20 between heat/pressure members and the interconnect members and applying heat and pressure for simultaneously connecting the front and back surface electrodes and the interconnect members.

23. A solar cell module comprising a single solar cell having an electrode for extracting power therefrom and an interconnect member connected to the electrode, which is manufactured by the method of claim 21 or 22.

24. A solar cell module comprising a plurality of arranged solar cells as set forth in claim 23, wherein power-extracting electrodes of adjacent solar cells are connected by the interconnect member.
